# FASCICULE DE BREVET EUROPEEN

(11) **EP 3 104 143 B1**
(45) Date de publication et mention de la délivrance du brevet: **01.08.2018**
(21) Numéro de dépôt: 16170014.1
(22) Date de dépôt: 17.05.2016
(51) Int. Cl.: G01J 1/44, H01L 31/04, H01L 31/042, G01R 31/40, H02J 7/35, G01J 1/42

(54) **SYSTÈME COMPRENANT UNE CELLULE PHOTOVOLTAÏQUE ET UN DISPOSITIF DE MESURE D'INTENSITÉ LUMINEUSE, ET PROCÉDÉ DE MESURE D'UNE INTENSITÉ LUMINEUSE REÇUE PAR CETTE CELLULE PHOTOVOLTAÏQUE**
SYSTEM, DAS EINE FOTOVOLTAIKZELLE UND EINE MESSVORRICHTUNG DER LICHTINTENSITÄT UMFASST, SOWIE VERFAHREN ZUR MESSUNG DER LICHTINTENSITÄT, DIE BEI DIESER FOTOVOLTAIKZELLE EINGEHT
SYSTEM COMPRISING A PHOTOVOLTAIC CELL AND A DEVICE FOR MEASURING LIGHT INTENSITY, AND METHOD FOR MEASURING A LIGHT INTENSITY RECEIVED BY SAID PHOTOVOLTAIC CELL

(30) Priorité: 10.06.2015 EP 15171527
(43) Date de publication de la demande: 14.12.2016
(73) Titulaire: EM Microelectronic-Marin SA, 2074 Marin (CH)
(72) Inventeur: Saby, Jérôme, 2000 Neuchâtel (CH); Théoduloz, Yves, 1400 Yverdon (CH); Marti, Cyril, 2523 Lignières (CH)
(74) Mandataire: Surmely, Gérard

(56) Documents cités:
- EP-A2- 1 925 923
- WO-A1-2007/010326
- WO-A1-2009/088310

## Description

### Domaine de l'invention

L'invention concerne un système comprenant une cellule photovoltaïque, une unité de stockage d'énergie électrique reçue par cette cellule photovoltaïque, un convertisseur DCDC agencé entre la cellule photovoltaïque et l'unité de stockage et ayant en entrée une capacité externe agencée en parallèle à ce convertisseur DCDC.

Plus particulièrement, la présente invention concerne un dispositif de mesure de l'intensité lumineuse reçue par une cellule photovoltaïque dont la fonction première est la production d'énergie électrique, cette cellule photovoltaïque étant reliée à cet effet à une unité de stockage d'énergie électrique. Un tel dispositif est aussi nommé un luxmètre.

L'invention concerne aussi un procédé de mesure de l'intensité lumineuse reçue par une cellule photovoltaïque reliée en sortie électriquement à une unité de stockage d'énergie électrique via un convertisseur DCDC et à une capacité externe agencée en parallèle à ce convertisseur DCDC.

### Arrière-plan de l'invention

Plusieurs types de luxmètres sont connus de l'homme du métier. Un premier type contient un capteur de lumière photoconducteur. Cette solution présente un problème de non linéarité de la tension aux bornes du capteur en fonction de la lumière reçue. Un autre type utilise une photodiode ou phototransistor.

Dans le cas d'un système incorporant une cellule photovoltaïque comme source d'énergie électrique, il est avantageux d'éviter d'ajouter un capteur spécifique pour la mesure de l'intensité lumineuse. En effet, il est connu d'utiliser une cellule photovoltaïque dans un luxmètre. Le problème est de réaliser une telle mesure de manière précise et sans diminuer le rendement de la charge d'un élément de stockage de l'énergie électrique fournie par la cellule photovoltaïque. La solution relativement simple consisterait à mesurer la tension à vide (tension de sortie pour laquelle la cellule photovoltaïque ne délivre aucun courant), mais une telle solution donne un résultat peu précis car la tension à vide varie peu en fonction de l'intensité lumineuse reçue et en plus cette variation n'est pas linéaire en fonction de l'intensité lumineuse.

Une mesure de l'intensité lumineuse via la cellule photovoltaïque pose un problème technique étant donné les conditions liées à un système performant avec une ou plusieurs cellule(s) photovoltaïque(s). Un tel système comprend un élément de stockage (capacité de stockage ou batterie) relié à la borne de sortie de la cellule photovoltaïque via un convertisseur DCDC ayant en entrée une capacité externe agencée en parallèle. Cette capacité externe a généralement une valeur relativement élevée, notamment de plusieurs microfarads. Elle est nécessaire au bon rendement de ce convertisseur. Ensuite, la cellule solaire peut généralement produire un courant électrique sur une large plage, notamment de quelques microampères à quelques milliampères. De plus, pour effectuer une mesure de l'intensité lumineuse, il est préférable qu'une telle mesure puisse être effectuée dans un intervalle de temps assez court, par exemple inférieur à 100 millisecondes (100 ms). WO2009/088310 A1 et EP1925923 A2 divulguent des systèmes et procédés de mesure pour déterminer l'intensité lumineuse reçue par des cellules photovoltaïques.

### Résumé de l'invention

La présente invention a pour but de proposer un dispositif de mesure de l'intensité lumineuse (luxmètre) reçue par une cellule photovoltaïque, servant à l'alimentation électrique d'un dispositif électronique (par exemple une montre ou un téléphone portable), qui soit précis, efficace et qui perturbe le moins possible le rendement de l'alimentation électrique du système de captage d'énergie lumineuse qui incorpore la cellule photovoltaïque utilisée comme source d'énergie électrique et également comme capteur pour le luxmètre.

Dans le cadre de la présente invention, les inventeurs ont premièrement cherché quelle grandeur physique peut avantageusement être considérée pour la mesure d'intensité lumineuse. Si la tension à vide n'est pas un bon candidat, il s'avère que le courant de court-circuit d'une cellule photovoltaïque permet de donner une bonne information sur l'intensité lumineuse qu'elle reçoit. En effet, le courant de court-circuit varie sensiblement de manière linéaire avec l'intensité lumineuse.

La présente invention propose un dispositif de mesure de l'intensité lumineuse reçue par une cellule photovoltaïque selon la revendication 1 de la présente demande de brevet. Elle propose aussi un système selon la revendication 4 comprenant un tel dispositif de mesure et une cellule photovoltaïque ayant une borne de sortie reliée en parallèle à un convertisseur DCDC, à une capacité externe et au dispositif de mesure. Finalement, la présente invention propose un procédé de mesure d'une intensité lumineuse reçue par une cellule photovoltaïque selon la revendication indépendante 6. Diverses variantes avantageuses font l'objet des revendications dépendantes.

Grâce aux caractéristiques de l'invention, le rendement de l'alimentation électrique d'un élément de stockage par la cellule photovoltaïque n'est quasi pas diminué par le dispositif de mesure proposé, notamment grâce au fait qu'aucun élément résistif, par exemple un interrupteur, n'est agencé entre la borne de sortie de la cellule photovoltaïque et l'entrée du convertisseur DCDC pour effectuer la mesure d'intensité lumineuse. Ensuite, grâce à l'unité de décharge de la capacité externe, laquelle est avantageusement agencée pour décharger cette capacité externe au travers d'une résistance de petite valeur, en particulier celle d'un transistor formant interrupteur, il est possible d'amener rapidement la tension aux bornes de cette capacité à une tension de référence relativement basse, de manière à pouvoir détecter un courant de sortie de la cellule photovoltaïque proche ou sensiblement égal au courant de court-circuit qui varie linéairement avec l'intensité lumineuse. Ainsi, le procédé de mesure peut être réalisé sur une relativement courte période sans interrompre la liaison électrique entre la borne de sortie de la cellule photovoltaïque et la capacité externe.

### Brève description des dessins

L'invention sera décrite ci-après à l'aide de dessins annexés, donnés à titre d'exemples nullement limitatifs, dans lesquels :
- La Figure 1 montre schématiquement un mode de réalisation général d'un système incorporant une cellule photovoltaïque et un circuit de mesure de l'intensité lumineuse reçue par cette cellule photovoltaïque;
- La Figure 2 est un schéma fonctionnel du circuit de mesure de l'intensité lumineuse;
- La Figure 3 montre des graphes de la tension de sortie en fonction du courant de sortie d'une cellule photovoltaïque pour diverses intensités lumineuses;
- La Figure 4 est un mode de réalisation d'une unité de charge & décharge de la capacité externe comprise dans une variante du circuit de mesure de la Figure 2;
- La Figure 5 est un mode de réalisation d'un détecteur d'évolution de la tension à la sortie de la cellule photovoltaïque qui est agencé dans une variante du circuit de mesure d'intensité lumineuse de la Figure 2;
- La Figure 6 montre les graphes temporels des signaux de commande et du signal de sortie de l'unité de charge & décharge de la Figure 4;
- La Figure 7 montre les graphes temporels des signaux de commande et du signal de sortie du détecteur d'évolution de la tension de la Figure 5;
- La Figure 8 montre une pluralité de plages d'intensité lumineuse définies par diverses valeurs de résistance d'une pluralité de valeurs de résistance prises par une résistance variable agencée dans une variante du circuit de mesure d'intensité lumineuse de la Figure 2; et
- La Figure 9 est un graphe temporel d'une évolution de la tension de sortie d'une cellule photovoltaïque, dont on mesure l'intensité lumineuse qu'elle reçoit, selon un mode de mise en oeuvre d'un procédé de mesure de l'intensité lumineuse reçue par une telle cellule photovoltaïque.

### Description détaillée de l'invention

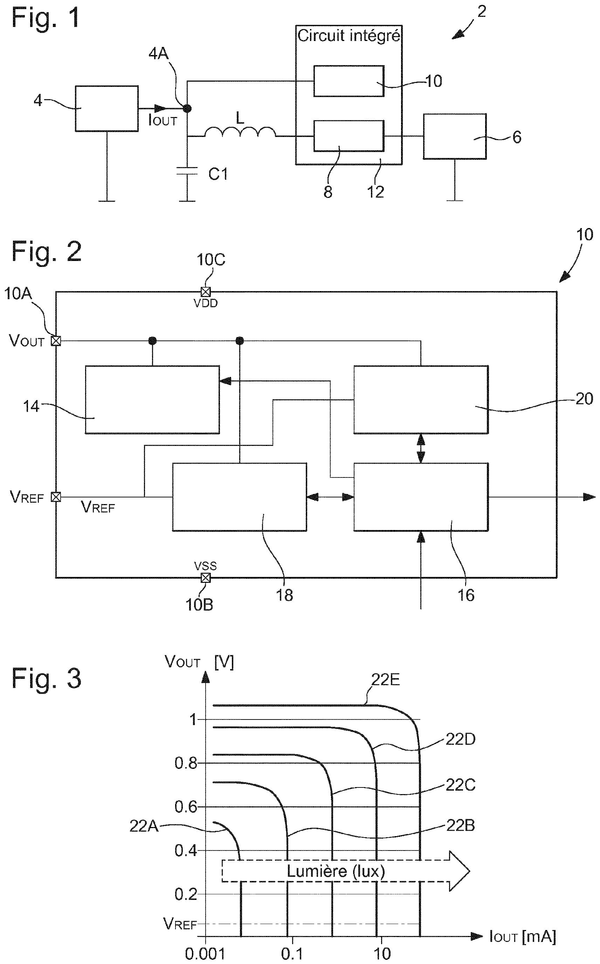

A l'aide des Figures 1 à 3 on décrira ci-après un mode de réalisation général d'un système de captage d'énergie lumineuse 2 comprenant une cellule photovoltaïque 4 reliée en sortie électriquement à une unité de stockage d'énergie électrique 6 via un convertisseur DCDC 8 et à une capacité externe C1 agencée en parallèle à ce convertisseur DCDC. Ce système 2 comprend en outre selon l'invention un dispositif de mesure 10 d'intensité lumineuse reçue par la cellule photovoltaïque. De préférence, le dispositif de mesure et le convertisseur 8 sont intégrés dans un même circuit intégré 12. On notera cependant que, dans d'autres variantes, le dispositif de mesure est formé par un circuit intégré distinct du convertisseur.

La borne d'entrée 10A du dispositif de mesure 10 est reliée à une borne de sortie 4A de la cellule photovoltaïque 4 en parallèle au convertisseur DCDC et à la capacité externe C1.

Le dispositif de mesure 10 comprend :
- une résistance variable 14 agencée entre ladite borne d'entrée 10A du dispositif de mesure et la borne de terre VSS, référencée 10B;
- une unité de commande 16 agencée notamment pour varier la valeur de la résistance variable 14 parmi une pluralité de valeurs de résistance déterminées;
- une unité de décharge 18 de la capacité externe C1, cette unité de décharge étant commandée par l'unité de commande de manière à pouvoir décharger cette capacité externe jusqu'à ce que la tension aux bornes de cette capacité externe soit sensiblement égale à une tension de référence V_{REF}; et
- un détecteur 20 de l'évolution de la tension de sortie V_{OUT} de la cellule photovoltaïque fournie en entrée du dispositif de mesure, ce détecteur étant commandé par l'unité de commande 16 et agencé pour pouvoir déterminer lors d'une mesure si la tension à la borne d'entrée 10A augmente ou diminue entre deux instants séparés par un intervalle de temps donné.

L'unité de commande 16 est agencée pour déterminer, parmi la pluralité de valeurs de résistance de la résistance variable 14, une première valeur de résistance et une deuxième valeur de résistance successives pour lesquelles le détecteur d'évolution de la tension de sortie V_{OUT} détecte respectivement une diminution de tension et une augmentation de tension à la borne d'entrée 10A ou, le cas échéant, pour déterminer que le courant I_{OUT} fourni par la cellule photovoltaïque est soit inférieur à la tension de référence V_{REF} divisée par la valeur maximale de la pluralité de valeurs de résistance de la résistance variable, soit supérieur à la tension de référence divisée par la valeur minimale de cette pluralité de valeurs de résistance.

Le dispositif de mesure 10 est ainsi agencé pour déterminer la plage de courant dans laquelle se trouve la valeur du courant I_{OUT} fourni par la cellule photovoltaïque à la tension de référence parmi une pluralité de plages de courant déterminées. Ce dispositif est alimenté sous une tension d'alimentation VDD, référencée 10C et fournie par l'élément de stockage 6. La tension de référence V_{REF} est de préférence choisie suffisamment petite pour que le courant I_{OUT} fourni par la cellule photovoltaïque 4 à cette tension de référence soit proche ou sensiblement égal au courant de court-circuit de cette cellule photovoltaïque. Dans ce dernier cas, on sait que cette valeur de courant est théoriquement une fonction linéaire de l'intensité lumineuse reçue par cette cellule photovoltaïque, de sorte que ces plages de courant définissent des plages d'intensité lumineuse correspondantes dont les valeurs extrêmes sont linéairement dépendantes des valeurs extrêmes des plages de courant susmentionnées. On notera toutefois que dans une variante moins favorable, on peut prévoir une tension de référence plus élevée. En effet, bien que la dépendance linéaire soit un avantage, ceci n'est pas une nécessité dans la mesure où l'on souhaite indiquer un niveau d'intensité lumineuse. Si toutefois on désire fournir plus précisément une information d'intensité lumineuse, la connaissance de la caractéristique V_{OUT} en fonction du courant I_{OUT} et de l'intensité lumineuse, pour la cellule photovoltaïque incorporée dans le système concerné, permet par un algorithme implémenté dans le circuit de commande ou dans un circuit de traitement additionnel de fournir un tel résultat.

Dans un exemple de réalisation non limitatif, pour une cellule photovoltaïque présentant sensiblement les courbes caractéristiques 22A à 22E de la Figure 3 pour respectivement des intensités lumineuses dont les valeurs respectives sont 10ⁿ lux, n = 1 à 5, avec le courant I_{OUT} pouvant varier dans une large plage de valeurs allant d'un micro-ampère à plusieurs milliampères (l'échelle du courant I_{OUT} étant ici logarithmique), on a :
- une capacité externe C1 de plusieurs microfarads, dont la valeur est notamment comprise entre 4 µF et 12 µF;
- une résistance variable 14 formée d'une pluralité de résistances Rₘ , m=1 à 8, avec R₁ = 7kΩ et Rₘ₊₁ = Rₘ/2;
- une tension de référence V_{REF} = 70 mV.

Dans une variante particulière, la capacité externe C1 a une valeur supérieure ou sensiblement égale à un microfarad (1 µF) et la valeur maximale de la pluralité de valeurs de résistance est supérieure ou sensiblement égale à un kilo-Ohm (1 KΩ). Dans une autre variante particulière, on a une pluralité de résistances Rₘ, m=1 à 16, avec R₁ = 70 kΩ et Rₘ₊₁ = Rₘ/2. Dans une variante spécifique, la tension de référence est sélectionnée de manière que son ordre de grandeur soit du dixième de la tension à vide moyenne (I_{OUT} = 0) de la cellule photovoltaïque dans la plage d'intensité lumineuse générale détectée par le dispositif de mesure. Par exemple, pour une tension à vide moyenne comprise entre un et deux Volt (1 - 2 V), la tension de référence est prévue entre 50 mV et 250 mV.

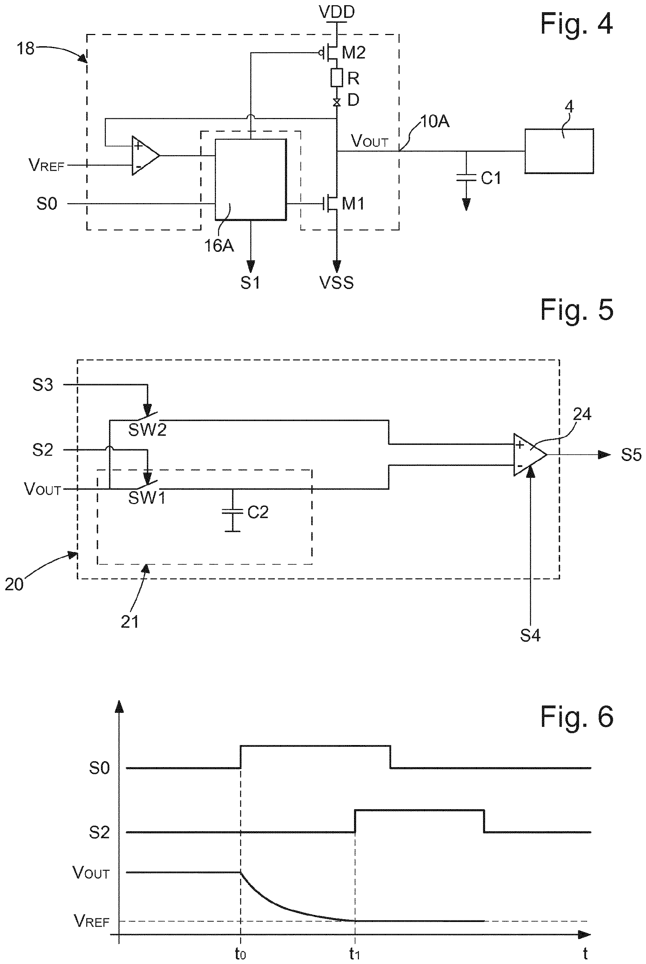

Selon un mode de réalisation préféré, l'unité de décharge 18 est également agencée pour charger la capacité externe C1 dans le cas où la tension initiale aux bornes de cette capacité externe est inférieure à la tension de référence. Dans ce cas, l'unité de décharge définit ainsi une unité de charge-décharge 18. La fonction de décharge est importante pour permettre d'effectuer une mesure rapide de l'intensité lumineuse, notamment dans une période inférieure à 100 millisecondes, malgré la présence d'une capacité externe C1 de plusieurs microfarad. En effet, dans une variante préférée représentée à la Figure 4, l'unité de charge-décharge 18 comprend un interrupteur agencé entre la borne d'entrée 10A et la borne de terre VSS, cet interrupteur étant formé par un transistor M1 commandé par l'unité de commande (bloc 16A) de manière que ce transistor puisse être soit conducteur, soit non conducteur. L'unité de commande est agencée pour commuter le transistor d'un état non-conducteur à un état conducteur lors d'une étape de décharge de la capacité externe C1 et pour rendre à nouveau ce transistor non-conducteur dès que la tension aux bornes de cette capacité externe est sensiblement égale à la tension de référence V_{REF}, cet instant étant déterminé à l'aide d'un comparateur recevant sur ses deux entrées V_{OUT} et V_{REF}. L'avantage d'utiliser un transistor dans l'unité de décharge vient du fait que sa résistance dans son état 'ON' est très petite, par exemple de 10 Ω. Ainsi la constante de temps RC est relativement petite; ce qui permet d'atteindre rapidement la faible tension de référence même lorsque que la tension initiale de la capacité externe, et donc la tension initiale aux bornes de la cellule photovoltaïque, est relativement élevée.

Dans une variante moins efficace, on peut toutefois utiliser la plus petite valeur de résistance de la résistance variable 14. En plus du chemin de décharge de la capacité externe C1 au travers du transistor M1 lors d'une mesure d'intensité lumineuse, il est prévu un chemin de charge de la capacité externe qui est important pour implémenter un algorithme de dichotomie qui sera exposé par la suite. Ce chemin de charge est agencé entre la borne 10A et la tension d'alimentation positive VDD et il comprend un interrupteur formé par un transistor M2 agencé en série avec une résistance R de limitation du courant de charge et une diode D. L'unité de commande (bloc 16A) est agencée pour commuter le transistor M2 d'un état non-conducteur à un état conducteur lors d'une étape de charge de la capacité externe C1 et pour rendre à nouveau ce transistor non-conducteur dès que la tension aux bornes de cette capacité externe est sensiblement égale à la tension de référence V_{REF}.

A la Figure 5 est représenté un mode de réalisation du détecteur 20 de l'évolution de la tension de sortie V_{OUT} de la cellule photovoltaïque 4. Ce détecteur 20 reçoit ainsi en entrée la tension V_{OUT} présente à la borne d'entrée 10A du dispositif de mesure. Il est formé essentiellement de quatre éléments : Un premier interrupteur SW1 commandé par un signal S2, une capacité C2 formant avec l'interrupteur SW1 une cellule mémoire 21 pour la tension V_{OUT}, un deuxième interrupteur SW2 commandé par un signal S3 et un comparateur 24 activé par un signal S5 et ayant ses deux entrées respectivement connectées aux bornes de sortie des deux interrupteurs SW1 et SW2. Ces deux interrupteurs ont leurs bornes d'entrée connectées à la borne d'entrée 10A. Les signaux S2, S3 et S4 sont fournis par l'unité de commande 16. Le détecteur 20 fournit en sortie un signal binaire S5 indiquant si le résultat de la comparaison par le comparateur 24 est positif ou négatif. Un signal positif indique une augmentation de la tension V_{OUT} alors qu'un signal négatif indique une diminution de cette tension V_{OUT} car l'interrupteur SW2 est activé (rendu conducteur) dans une période ultérieure à celle où l'interrupteur SW1 est activé.

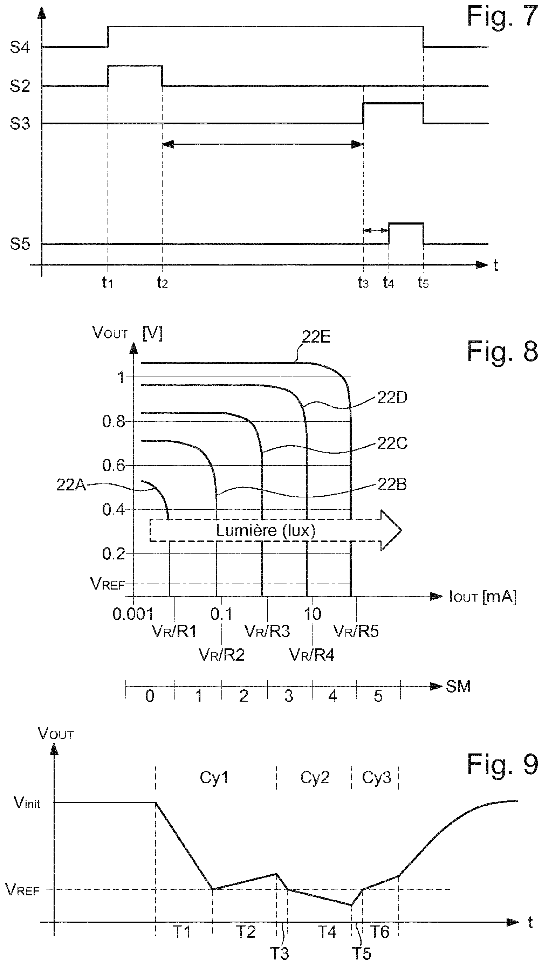

En référence aux Figures 6 et 7, on décrira le fonctionnement des unités 18 et 20 et leur interaction. Le bloc logique 16A reçoit un signal S0 de début de cycle intervenant dans une mesure d'intensité lumineuse. Dans le cas où la tension V_{OUT} est initialement supérieure à la tension de référence, comme représenté à la Figure 6, le signal S0 rend le transistor M1 conducteur au temps t₀ de manière à décharger rapidement la capacité C1 jusqu'à ce que sa tension atteigne sensiblement la tension de référence. A ce moment, le comparateur indique au bloc logique 16A cet événement. Ce bloc logique rend alors le transistor M1 non conducteur et envoie simultanément un signal S1 au temps t₁ à l'unité centrale de l'unité de commande 16. La réception de ce signal sert à l'activation immédiate de l'unité 20 sensiblement à cet instant t₁, comme représenté à la Figure 7. L'unité de commande envoie alors un signal S2 à l'unité 20 pour fermer l'interrupteur SW1, de manière à charger la capacité C2 à la tension de référence, et un signal S4 d'activation du comparateur 24. Après un certain intervalle de temps, l'interrupteur SW1 est à nouveau ouvert à l'instant t₂ et la tension V_{OUT} sensiblement égale à la tension V_{REF} est temporairement mémorisée dans la capacité C2. Ensuite, après avoir sélectionné une valeur de résistance pour la résistance variable 14, l'unité de commande laisse le système évoluer un certain intervalle de temps jusqu'à l'instant t₃ où il ferme l'interrupteur SW2, de sorte que le comparateur 24 reçoit alors en entrée la tension aux bornes de la capacité C2 sensiblement égale à V_{REF} et la tension V_{OUT} après le temps t₃. Le comparateur fournit, après un intervalle de temps d'établissement de la comparaison, dès l'instant t₄ un signal S5 indiquant le résultat de la comparaison à l'unité de commande 16 qui enregistre ce résultat dans l'intervalle de temps t₄ - t₅. Ensuite, l'unité de commande désactive l'unité 20 à l'instant t₅ mettant ainsi fin au cycle de mesure.

Le dispositif de mesure de l'invention est agencé pour permettre de déterminer deux valeurs successives quelconques dans la pluralité de valeurs de résistance de la résistance variable qui définissent une plage de courant respective pour le courant fourni par la cellule photovoltaïque à la tension de référence, chacune des plages de courant définissant ainsi une plage de valeurs respective pour l'intensité lumineuse pouvant être reçue ou captée par la cellule photovoltaïque comme représenté à la Figure 8. Le dispositif de mesure est agencé pour déterminer quelle plage d'intensité lumineuse correspond à la valeur d'intensité lumineuse reçue ou captée par la cellule photovoltaïque et pour indiquer cette information SM au moyen d'un affichage qui est associé à ce dispositif de mesure.

On décrira ci-après le fonctionnement du dispositif de mesure de l'invention et en particulier un procédé de mesure d'une intensité lumineuse également objet de la présente invention. Ce procédé mesure l'intensité lumineuse reçue par une cellule photovoltaïque reliée en sortie électriquement à une unité de stockage d'énergie électrique via un convertisseur DCDC et à une capacité externe agencée en parallèle à ce convertisseur DCDC, comme décrit précédemment. Ce procédé de mesure est de préférence mis en oeuvre au moyen d'un dispositif de mesure de l'intensité lumineuse dont une borne d'entrée est reliée à une borne de sortie de la cellule photovoltaïque en parallèle au convertisseur DCDC et à la capacité externe, comme décrit précédemment.

De manière générale, le procédé de mesure comprend les étapes suivantes :
A) Connecter une résistance variable 14 entre la borne d'entrée 10A du dispositif de mesure 10 et une borne de terre 10B, cette résistance variable étant agencée pour prendre diverses valeurs parmi une pluralité de valeurs de résistance déterminées et étant programmée par une unité de commande 16 du dispositif de mesure; et sélectionner une valeur de résistance initiale;
B) Décharger ou charger la capacité externe C1 dans le cas où la tension aux bornes de cette capacité externe est supérieure à une tension de référence V_{REF}, respectivement inférieure à cette tension de référence, jusqu'à ce que la tension aux bornes de la capacité externe C1 soit sensiblement égale à la tension de référence;
C) Déterminer si la tension de la borne d'entrée augmente ou diminue entre un premier instant où cette tension est sensiblement égale à la tension de référence suite à l'étape B) et un deuxième instant ultérieur donné par l'unité de commande;
D) Répéter les étapes B) et C) soit en diminuant la valeur de la résistance variable si le résultat de l'étape C) lors d'une itération précédente indique une augmentation de la tension à la borne d'entrée et si la valeur de la résistance variable lors de cette itération précédente ne correspondait pas à la valeur minimale de la pluralité de valeurs de résistance, soit en augmentant la valeur de la résistance variable si le résultat de l'étape C) lors d'une itération précédente indique une diminution de la tension à la borne d'entrée et si la valeur de la résistance variable lors de cette itération précédente ne correspondait pas à la valeur maximale de la pluralité de valeurs de résistance, et effectuer cette étape D) jusqu'à la détermination, parmi la pluralité de valeurs de résistance, d'une première valeur de résistance et d'une deuxième valeur de résistance successives pour lesquelles le détecteur de l'évolution de la tension de sortie détecte respectivement une diminution de tension et une augmentation de tension à la borne d'entrée ou, le cas échéant, jusqu'à la détermination que le courant fourni par la cellule photovoltaïque est soit inférieur à la tension de référence divisée par la valeur maximale de la pluralité de valeurs de résistance, soit supérieur à la tension de référence divisée par la valeur minimale de cette pluralité de valeurs de résistance.

Dans une variante préférée, la tension de référence est prévue suffisamment petite pour que le courant fourni par la cellule photovoltaïque à cette tension de référence soit proche ou sensiblement égal au courant de court-circuit de cette cellule photovoltaïque.

On décrira ci-après, à l'aide de la Figure 9, un mode de mise en oeuvre spécifique du procédé de mesure selon l'invention dans lequel un algorithme de dichotomie est implémenté pour la sélection de la valeur de résistance initiale et lors des sélections successives de valeurs de résistance lors de l'étape D) mentionnée précédemment. Le procédé de mesure est conçu pour déterminer deux valeurs successives quelconques dans la pluralité de valeurs de résistance définissant une plage de courant respective pour le courant fourni par la cellule photovoltaïque à la tension de référence, chacune des plages de courant définissant ainsi une plage de valeurs pour l'intensité lumineuse pouvant être reçue ou captée par la cellule photovoltaïque. Le procédé de mesure détermine la plage de valeurs correspondant à l'intensité lumineuse effectivement reçue ou captée par la cellule photovoltaïque. Dans le cas où le procédé de mesure détermine que le courant fourni par la cellule photovoltaïque est soit inférieur à la tension V_{REF} divisée par la valeur maximale de la pluralité de valeurs de résistance, soit supérieur à cette tension V_{REF} divisée par la valeur minimale de cette pluralité de valeurs de résistance, il conclut que l'intensité lumineuse reçue ou captée à une valeur située dans une plage d'extrémité inférieure, respectivement une plage d'extrémité supérieure.

Le graphe de la Figure 9 montre schématiquement l'évolution de la tension de sortie V_{OUT} au cours d'une mesure implémentant un algorithme de dichotomie dans le cas d'une résistance variable avec huit résistances (Rₙ, n = 1 à 8 ; Rₙ₊₁ < Rₙ). La tension V_{OUT} a généralement une tension initiale Vᵢₙᵢₜ supérieure à la tension V_{REF}. Lors d'un premier cycle Cy1, la tension V_{OUT} est abaissée jusqu'à la tension V_{REF} au cours d'une première période T1 à l'aide de l'unité 18. Ensuite, on sélectionne la résistance milieu R₄ et l'unité 20 est activée dans la période T2. Comme exposé précédemment, dans la phase finale de cette période T2, le dispositif de mesure a détecté que la tension V_{OUT} a augmenté au cours de cette période T2. Il en déduit que le courant I_{OUT} fourni par la cellule photovoltaïque est supérieur à un courant de référence défini par V_{REF} / R4, et donc que la résistance R4 est trop élevée. Un deuxième cycle Cy2, similaire au premier cycle, est alors prévu avec la sélection de la résistance R6. Lors d'une courte période T3, la tension V_{OUT} est à nouveau ramenée à la tension V_{REF} par l'unité 18 et l'unité 20 est ensuite activée durant la période T4, cette unité 20 déterminant à nouveau l'évolution de la tension V_{OUT} au cours de cette période T4. Dans la phase finale de cette période T4, le dispositif de mesure a détecté que la tension V_{OUT} a diminuée au cours de cette période et il en déduit que le courant I_{OUT} est inférieur à un courant de référence défini par V_{REF} / R6, et donc que la résistance R6 est trop petite. Un troisième et dernier cycle Cy3, similaire au deuxième cycle, est alors prévu avec la sélection de la résistance R5. Ce dernier cycle, comprenant les périodes T5 et T6 similaires aux périodes T3 et T4, indique que la tension évolue à nouveau positivement de sorte que le courant I_{OUT} fourni par la cellule photovoltaïque est supérieur à un courant de référence défini par V_{REF} / R5, et donc que la résistance R5 est trop élevée. Le dispositif de mesure termine alors la mesure d'intensité lumineuse en indiquant que le courant I_{OUT} est donc situé dans une plage entre les courants de référence V_{REF} / R5 et V_{REF} / R6, cette plage correspondant à une plage d'intensité lumineuse donnée pour la cellule photovoltaïque.

Finalement, dans un mode de réalisation particulier, il est prévu, suite au procédé de mesure décrit précédemment, de déterminer précisément la valeur du courant I_{OUT} fourni par la cellule photovoltaïque. A cet effet, le dispositif de mesure sélectionne la première valeur de résistance ou la deuxième valeur de résistance successives de la résistance variable déterminées lors de la mesure précédente (dans l'exemple ci-dessus, la résistance R5 ou R6) et laisse la résistance variable connectée à la borne d'entrée 10A. Après un certain intervalle de temps permettant au système d'être en régime établi, il mesure précisément la tension V_{OUT} au moyen d'un convertisseur AN (analogique-numérique) et détermine ainsi précisément la valeur du courant I_{OUT} qui correspond sensiblement au courant de court-circuit et ensuite la valeur de l'intensité lumineuse captée en utilisant la caractéristique linéaire de l'intensité lumineuse en fonction du courant de court-circuit pour la cellule photovoltaïque concernée.

## Revendications

1. Dispositif de mesure (2) de l'intensité lumineuse reçue par une cellule photovoltaïque (4) qui a une borne de sortie reliée électriquement à une unité de stockage d'énergie électrique (6) via un convertisseur DCDC (8) et à une capacité externe (C1) agencée en parallèle à ce convertisseur DCDC ; **caractérisé en ce que** ce dispositif de mesure a une borne d'entrée (10A) destinée à être reliée à ladite borne de sortie de la cellule photovoltaïque en parallèle au convertisseur DCDC et à la capacité externe, ce dispositif de mesure comprenant :
- une résistance variable (14) agencée entre ladite borne d'entrée du dispositif de mesure et une borne de terre;
- une unité de commande (16) agencée pour varier la valeur de la résistance variable parmi une pluralité de valeurs de résistance déterminées;
- une unité de décharge (18) de la capacité externe (C1) commandée par l'unité de commande de manière à pouvoir décharger cette capacité externe jusqu'à ce que la tension aux bornes de cette capacité externe soit sensiblement égale à une tension de référence; et
- un détecteur (20) de l'évolution de la tension à ladite borne d'entrée correspondant à la tension de sortie de la cellule photovoltaïque, ce détecteur étant commandé par l'unité de commande et agencé pour pouvoir déterminer lors d'une mesure si la tension à la borne d'entrée augmente ou diminue entre deux instants séparés par un intervalle de temps donné;
et **en ce que** l'unité de commande est agencée pour déterminer, parmi ladite pluralité de valeurs de résistance, une première valeur de résistance et une deuxième valeur de résistance successives pour lesquelles le détecteur de l'évolution de la tension à ladite borne d'entrée détecte respectivement une diminution de tension et une augmentation de tension à cette borne d'entrée ou, le cas échéant, pour déterminer que le courant fourni par ladite cellule photovoltaïque à ladite borne de sortie est soit inférieur à la tension de référence divisée par la valeur maximale de ladite pluralité de valeurs de résistance, soit supérieur à la tension de référence divisée par la valeur minimale de cette pluralité de valeurs de résistance.

2. Dispositif de mesure selon la revendication 1, **caractérisé en ce que** ladite unité de décharge comprend un interrupteur agencé entre ladite borne d'entrée et ladite borne de terre, cet interrupteur étant formé par un transistor (M1) commandé par ladite unité de commande de manière que ce transistor puisse être soit conducteur, soit non conducteur, et **en ce que** l'unité de commande est agencée pour commuter ledit transistor d'un état non-conducteur à un état conducteur lors d'une étape de décharge de la capacité externe par ce dispositif de mesure et pour rendre à nouveau ce transistor non-conducteur dès que la tension à ladite borne d'entrée, correspondant à la tension aux bornes de la capacité externe, est sensiblement égale à ladite tension de référence.

3. Dispositif de mesure selon la revendication 1 ou 2, **caractérisé en ce que** ladite unité de décharge est également agencée pour charger ladite capacité externe dans le cas où la tension à ladite borne d'entrée, correspondant à une tension initiale aux bornes de cette capacité externe, est inférieure à ladite tension de référence, cette unité de décharge définissant ainsi une unité de charge-décharge.

4. Système comprenant un dispositif de mesure selon l'une quelconque des revendications précédentes, une cellule photovoltaïque, un convertisseur DCDC et une capacité externe (C1), le dispositif de mesure ayant une borne d'entrée (10A) reliée à une borne de sortie de la cellule photovoltaïque en parallèle au convertisseur DCDC et à la capacité externe, ce système étant **caractérisé en ce que** ladite tension de référence est prévue suffisamment petite pour que le courant fourni par la cellule photovoltaïque à cette tension de référence soit proche du ou sensiblement égal au courant de court-circuit de cette cellule photovoltaïque.

5. Système selon la revendication 4, **caractérisé en ce que** deux valeurs successives quelconques dans ladite pluralité de valeurs de résistance définissent une plage de courant respective pour le courant pouvant être fourni par la cellule photovoltaïque à la tension de référence, chacune des plages de courant définissant ainsi une plage de valeurs pour l'intensité lumineuse pouvant être reçue ou captée par la cellule photovoltaïque; et **en ce que** ledit dispositif de mesure est agencé pour déterminer quelle plage de valeurs correspond à l'intensité lumineuse effectivement reçue ou captée par la cellule photovoltaïque.

6. Procédé de mesure d'une intensité lumineuse reçue par une cellule photovoltaïque (4) reliée en sortie électriquement à une unité de stockage d'énergie électrique (6) via un convertisseur DCDC (8) et à une capacité externe (C1) agencée en parallèle à ce convertisseur DCDC, ce procédé de mesure étant mis en oeuvre au moyen d'un dispositif de mesure (2) de ladite intensité lumineuse dont une borne d'entrée (10A) est reliée à une borne de sortie de la cellule photovoltaïque en parallèle au convertisseur DCDC et à la capacité externe; ce procédé comprenant les étapes suivantes :
A) Connecter une résistance variable (14) entre ladite borne d'entrée du dispositif de mesure et une borne de terre, cette résistance variable étant agencée pour prendre diverses valeurs parmi une pluralité de valeurs de résistance déterminées et étant programmée par une unité de commande du dispositif de mesure, et sélectionner une valeur de résistance initiale;
B) Décharger ou charger la capacité externe dans le cas où la tension aux bornes de cette capacité externe est supérieure à une tension de référence, respectivement inférieure à cette tension de référence, jusqu'à ce que la tension aux bornes de la capacité externe soit sensiblement égale à la tension de référence;
C) Déterminer si la tension de ladite borne d'entrée augmente ou diminue entre un premier instant où cette tension est sensiblement égale à la tension de référence suite à l'étape B) et un deuxième instant ultérieur donné par ladite unité de commande;
D) Répéter les étapes B) et C) soit en diminuant la valeur de la résistance variable si le résultat de l'étape C) lors d'une itération précédente indique une augmentation de ladite tension à ladite borne d'entrée et si la valeur de la résistance variable lors de cette itération précédente ne correspondait pas à la valeur minimale de ladite pluralité de valeurs de résistance, soit en augmentant la valeur de la résistance variable si le résultat de l'étape C) lors d'une itération précédente indique une diminution de ladite tension à ladite borne d'entrée et si la valeur de la résistance variable lors de cette itération précédente ne correspondait pas à la valeur maximale de ladite pluralité de valeurs de résistance, et effectuer cette étape D) jusqu'à la détermination, parmi ladite pluralité de valeurs de résistance, d'une première valeur de résistance et d'une deuxième valeur de résistance successives pour lesquelles le détecteur de l'évolution de la tension de sortie détecte respectivement une diminution de tension et une augmentation de tension à ladite borne d'entrée ou, le cas échéant, jusqu'à la détermination que le courant fourni par ladite cellule photovoltaïque est soit inférieur à la tension de référence divisée par la valeur maximale de ladite pluralité de valeurs de résistance, soit supérieur à la tension de référence divisée par la valeur minimale de ladite pluralité de valeurs de résistance.

7. Procédé de mesure selon la revendication 6, **caractérisé en ce que** ladite tension de référence est prévue suffisamment petite pour que le courant fourni par la cellule photovoltaïque à cette tension de référence soit proche ou sensiblement égal au courant de court-circuit de cette cellule photovoltaïque.

8. Procédé de mesure selon la revendication 6 ou 7, **caractérisé en ce qu'**un algorithme de dichotomie est implémenté pour la sélection de ladite valeur de résistance initiale et lors des sélections successives de valeurs de résistance lors de ladite étape D).

9. Procédé de mesure selon l'une quelconque des revendications 6 à 8, **caractérisé en ce que** deux valeurs successives quelconques dans ladite pluralité de valeurs de résistance définissent une plage de courant respective pour le courant fourni par la cellule photovoltaïque à ladite tension de référence, chacune des plages de courant définissant ainsi une plage de valeurs pour l'intensité lumineuse pouvant être reçue ou captée par ladite cellule photovoltaïque; et **en ce que** le procédé de mesure détermine la plage de valeurs correspondant à l'intensité lumineuse effectivement reçue ou captée par la cellule photovoltaïque.

10. Procédé de mesure selon l'une quelconque des revendications 6 à 9, **caractérisé en ce que** qu'il comprend les étapes additionnelles ultérieures suivantes :
E) Sélectionner ladite première valeur de résistance ou ladite deuxième valeur de résistance successives de la résistance variable déterminées lors de l'étape D) et laisser la résistance variable connectée à ladite borne d'entrée du dispositif de mesure;
F) Après un certain intervalle de temps permettant au système d'être sensiblement en régime établi, mesurer la tension (V_{OUT}) à ladite borne d'entrée au moyen d'un convertisseur analogique-numérique et déterminer ainsi précisément la valeur du courant (I_{OUT}) fourni par ladite cellule photovoltaïque;
G) Déterminer la valeur de l'intensité lumineuse captée par la cellule photovoltaïque en utilisant la caractéristique linéaire de l'intensité lumineuse en fonction du courant de court-circuit pour cette cellule photovoltaïque.

## Patentansprüche

1. Vorrichtung (2) zum Messen der Lichtstärke, die von einer photovoltaischen Zelle (4) empfangen wird, die einen Ausgangsanschluss besitzt, der über einen Gleichspannungswandler (8) mit einer Einheit (6) zum Speichern von elektrischer Energie und mit einer externen Kapazität (C1) elektrisch verbunden ist, die zu diesem Gleichspannungswandler parallel angeordnet ist, **dadurch gekennzeichnet, dass** diese Messvorrichtung einen Eingangsanschluss (10A) besitzt, der dazu bestimmt ist, mit dem Ausgangsanschluss der photovoltaischen Zelle parallel zu dem Gleichspannungswandler und mit der externen Kapazität verbunden zu werden, wobei diese Messvorrichtung umfasst:
- einen veränderbaren Widerstand (14), der zwischen dem Eingangsanschluss der Messvorrichtung und einem Masseanschluss angeordnet ist;
- eine Steuereinheit (16), die dafür ausgelegt ist, den Wert des veränderbaren Widerstandes zwischen einer Mehrzahl von bestimmten Widerstandswerten zu verändern;
- eine Einheit (18) zum Entladen der externen Kapazität (C1), die durch die Steuereinheit in einer Weise gesteuert wird, dass diese externe Kapazität entladen werden kann, bis die Spannung an den Anschlüssen dieser externen Kapazität im Wesentlichen gleich einer Referenzspannung ist; und
- einen Detektor (20) für die Entwicklung der Spannung an dem Eingangsanschluss, die der Ausgangsspannung der photovoltaischen Zelle entspricht, wobei dieser Detektor durch die Steuereinheit gesteuert wird und dafür ausgelegt ist, bei einer Messung bestimmen zu können, ob die Spannung an dem Eingangsanschluss zwischen zwei Zeitpunkten, die durch ein gegebenes Zeitintervall getrennt sind, zunimmt oder abnimmt;
und dass die Steuereinheit dafür ausgelegt ist, unter der Mehrzahl von Widerstandswerten einen ersten Widerstandswert und einen zweiten Widerstandswert zu bestimmen, die aufeinander folgen und für die der Detektor für die Entwicklung der Spannung am Eingangsanschluss eine Spannungsabnahme und entsprechend eine Spannungszunahme an diesem Eingangsanschluss detektiert, oder um gegebenenfalls zu bestimmen, dass der von der photovoltaischen Zelle an den Ausgangsanschluss gelieferte Strom entweder kleiner als die Referenzspannung, dividiert durch den Maximalwert der Mehrzahl von Widerstandswerten, ist oder größer als die Referenzspannung, dividiert durch den Minimalwert dieser Mehrzahl von Widerstandswerten, ist.

2. Messvorrichtung nach Anspruch 1, **dadurch gekennzeichnet, dass** die Entladeeinheit einen Unterbrecher umfasst, der zwischen dem Eingangsanschluss und dem Masseanschluss angeordnet ist, wobei dieser Unterbrecher durch einen Transistor (M1) gebildet ist, der durch die Steuereinheit in einer Weise gesteuert wird, dass dieser Transistor entweder leitend oder nichtleitend sein kann, und dass die Steuereinheit dafür ausgelegt ist, den Transistor im Schritt des Entladens der externen Kapazität durch diese Messvorrichtung von einem nichtleitenden Zustand in einen leitenden Zustand umzuschalten und diesen Transistor erneut nichtleitend zu stellen, sobald die Spannung am Eingangsanschluss, die der Spannung an den Anschlüssen der externen Kapazität entspricht, im Wesentlichen gleich der Referenzspannung ist.

3. Messvorrichtung nach Anspruch 1 oder 2, **dadurch gekennzeichnet, dass** die Entladeeinheit ferner dafür ausgelegt ist, die externe Kapazität in dem Fall zu laden, in dem die Spannung am Eingangsanschluss, die einer Anfangsspannung an den Anschlüssen dieser externen Kapazität entspricht, kleiner als die Referenzspannung ist, weshalb diese Entladeeinheit eine Lade/Entladeeinheit bildet.

4. System, das eine Messvorrichtung nach einem der vorhergehenden Ansprüche, eine photovoltaische Zelle, einen Gleichspannungswandler und eine externe Kapazität (C1) umfasst, wobei die Messvorrichtung einen Eingangsanschluss (10A) besitzt, der mit einem Ausgangsanschluss der photovoltaischen Zelle parallel zu dem Gleichspannungswandler und mit der externen Kapazität verbunden ist, wobei dieses System **dadurch gekennzeichnet ist, dass** die Referenzspannung ausreichend klein vorgesehen ist, damit der von der photovoltaischen Zelle gelieferte Strom bei dieser Referenzspannung in der Nähe des Kurzschlussstroms dieser photovoltaischen Zelle liegt oder im Wesentlichen gleich dieser ist.

5. System nach Anspruch 4, **dadurch gekennzeichnet, dass** zwei beliebige aufeinanderfolgende Werte der Mehrzahl von Widerstandswerten einen jeweiligen Strombereich für den Strom definieren, der von der photovoltaischen Zelle bei der Referenzspannung geliefert werden kann, wobei jeder der Strombereiche somit einen Bereich von Werten für die Lichtstärke, die von der photovoltaischen Zelle empfangen oder aufgefangen werden kann, definiert; und dass die Messvorrichtung dafür ausgelegt ist, zu bestimmen, welcher Wertebereich der Lichtstärke entspricht, die von der photovoltaischen Zelle tatsächlich empfangen oder aufgefangen wird.

6. Verfahren zum Messen einer Lichtstärke, die von einer photovoltaischen Zelle (4) empfangen wird, die an ihrem Ausgang über einen Gleichspannungswandler (8) mit einer Einheit (6) zum Speichern von elektrischer Energie und mit einer externen Kapazität (C1) elektrisch verbunden ist, die parallel zu diesem Gleichspannungswandler angeordnet ist, wobei dieses Messverfahren mittels einer Vorrichtung (2) zum Messen der Lichtstärke ausgeführt wird, deren Eingangsanschluss (10A) mit einem Ausgangsanschluss der photovoltaischen Zelle parallel zu dem Gleichspannungswandler und mit der externen Kapazität verbunden ist; wobei dieses Verfahren die folgenden Schritte umfasst:
A) Verbinden eines veränderbaren Widerstandes (14) zwischen dem Eingangsanschluss der Messvorrichtung und einem Masseanschluss, wobei dieser veränderbare Widerstand dafür ausgelegt ist, dass er unterschiedliche Werte aus einer Mehrzahl von bestimmten Widerstandswerten annehmen kann und durch eine Steuereinheit der Messvorrichtung programmiert ist, und Auswählen eines anfänglichen Widerstandswertes;
B) Entladen oder Laden der externen Kapazität in dem Fall, in dem die Spannung an den Anschlüssen dieser externen Kapazität größer als eine Referenzspannung oder entsprechend kleiner als diese Referenzspannung ist, bis die Spannung an den Anschlüssen der externen Kapazität im Wesentlichen gleich der Referenzspannung ist;
C) Bestimmen, ob die Spannung des Eingangsanschlusses zwischen einem ersten Zeitpunkt, zu dem diese Spannung im Wesentlichen gleich der Referenzspannung nach dem Schritt B) ist, und einem zweiten, späteren Zeitpunkt, der durch die Steuereinheit gegeben ist, zunimmt oder abnimmt;
D) Wiederholen der Schritte B) und C), indem der Wert des veränderbaren Widerstandes verringert wird, falls das Ergebnis des Schrittes C) in einer vorhergehenden Iteration eine Zunahme der Spannung am Eingangsanschluss angibt und falls der Wert des veränderbaren Widerstandes in dieser vorhergehenden Iteration nicht dem Minimalwert der Mehrzahl von Widerstandswerten entspricht, oder indem der Wert des veränderbaren Widerstandes erhöht wird, falls das Ergebnis des Schrittes C) in einer vorhergehenden Iteration eine Abnahme der Spannung am Eingangsanschluss angibt und falls der Wert des veränderbaren Widerstandes in dieser vorhergehenden Iteration nicht dem Maximalwert der Mehrzahl von Widerstandswerten entspricht, und Ausführen dieses Schrittes D), bis unter der Mehrzahl von Widerstandswerten ein erster Widerstandswert und ein zweiter Widerstandswert bestimmt werden, die aufeinanderfolgen und für die der Detektor für die Entwicklung der Ausgangsspannung eine Abnahme der Spannung und entsprechend eine Zunahme der Spannung an dem Eingangsanschluss detektiert, oder bis gegebenenfalls bestimmt wird, dass der von der photovoltaischen Zelle gelieferte Strom kleiner als die Referenzspannung, dividiert durch den Maximalwert der Mehrzahl von Widerstandswerten, ist oder größer als die Referenzspannung, dividiert durch den Minimalwert der Mehrzahl von Widerstandswerten, ist.

7. Messverfahren nach Anspruch 6, **dadurch gekennzeichnet, dass** die Referenzspannung ausreichend klein vorgesehen ist, damit der von der photovoltaischen Zelle gelieferte Strom bei dieser Referenzspannung in der Nähe des Kurzschlussstroms dieser photovoltaischen Zelle liegt oder im Wesentlichen gleich diesem ist.

8. Messverfahren nach Anspruch 6 oder 7, **dadurch gekennzeichnet, dass** ein Dichotomie-Algorithmus für die Auswahl des anfänglichen Widerstandswertes und bei der aufeinanderfolgenden Auswahl von Widerstandswerten im Schritt D) implementiert ist.

9. Messverfahren nach einem der Ansprüche 6 bis 8, **dadurch gekennzeichnet, dass** zwei beliebige aufeinanderfolgende Werte der Mehrzahl von Widerstandswerten einen jeweiligen Strombereich für den von der photovoltaischen Zelle gelieferten Strom bei der Referenzspannung definieren, wobei jeder der Strombereiche somit einen Bereich von Werten für die Lichtstärke, die von der photovoltaischen Zelle empfangen oder aufgefangen werden kann, definiert; und dass das Messverfahren den Bereich von Werten bestimmt, der der Lichtstärke entspricht, die von der photovoltaischen Zelle tatsächlich empfangen oder aufgefangen werden kann.

10. Messverfahren nach einem der Ansprüche 6 bis 9, **dadurch gekennzeichnet, dass** es die folgenden zusätzlichen, späteren Schritte umfasst:
E) Auswählen des ersten Widerstandswertes oder des zweiten Widerstandswertes des veränderbaren Widerstandes, die aufeinanderfolgen und im Schritt D) bestimmt werden, und Aufrechterhalten des verbundenen Zustands des veränderbaren Widerstands mit dem Eingangsanschluss der Messvorrichtung;
F) Messen der Spannung (V_{OUT}) am Eingangsanschluss mittels eines Analog-Digital-Konverters und somit präzises Bestimmen des Wertes des von der photovoltaischen Zelle gelieferten Stroms (I_{OUT}) nach einem bestimmten Zeitintervall, das dem System ermöglicht, im Wesentlichen in einen stationären Betrieb überzugehen;
G) Bestimmen des Wertes der Lichtstärke, die von der photovoltaischen Zelle aufgefangen wird, unter Verwendung der linearen Charakteristik der Lichtstärke als Funktion des Kurzschlussstroms für diese photovoltaische Zelle.

## Claims

1. Device (2) for measuring the luminous intensity received by a photovoltaic cell (4) which has an output terminal electrically connected to an electrical energy storage unit (6) via a DC-DC converter (8) and to an external capacitor (C1) arranged in parallel to said DC-DC converter, **characterized in that** said measuring device has an input terminal (10A) intended to be connected to said output terminal of the photovoltaic cell in parallel to the DC-DC converter and to the external capacitor, said measuring device including:
- a variable resistor (14) arranged between said measuring device input terminal and an earth terminal;
- a control unit (16) arranged to vary the value of the variable resistor within a plurality of determined resistance values;
- a discharge unit (18) for the external capacitor (C1) controlled by the control unit so as to discharge said external capacitor until the voltage at the external capacitor terminals is substantially equal to a reference voltage; and
- a voltage change detector (20) for the voltage at said input terminal corresponding to the photovoltaic cell output voltage, said detector being controlled by the control unit and arranged to be capable of determining, when a measurement is made, whether the voltage at the input terminal increases or decreases between two instants separated by a given time interval;
and **in that** the control unit is arranged to determine, within said plurality of resistance values, successive first and second resistance values at which the voltage change detector at said input terminal respectively detects a decrease in voltage and an increase in voltage at said input terminal, or, if appropriate, to determine whether the current supplied by the photovoltaic cell to said output terminal is either lower than the reference voltage divided by the maximum value of the plurality of resistance values, or higher than the reference voltage divided by the minimum value of said plurality of resistance values.

2. Measuring device according to claim 1, **characterized in that** said charge unit includes a switch arranged beween said input terminal and said earth terminal, said switch being formed by a transistor (M1) controlled by said control unit such that said transistor can be either conductive, or non-conductive, and **in that** the control unit is arranged to switch said transistor from a non-conductive state to a conductive state in a step of discharging the external capacitor via said measuring device, and to make said transistor non-conductive again once the voltage at said input terminal, corresponding to the voltage at the external capacitor terminals, is substantially equal to said reference voltage.

3. Measuring device according to claim 1 or 2, **characterized in that** said discharge units is also arranged to charge said external capacitor if the voltage at said input terminal, corresponding to an initial voltage at said external capacitor terminals, is lower than said reference voltage, said discharge unit thus forming a charge - discharge unit.

4. System comprising a measuring device according to any of the preceding claims, a photovoltaic cell, a DC-DC converter and an external capacitor (C1), the measuring device having an input terminal (10A) connected to an output terminal of the photovoltaic cell in parallel to the DC-DC converter and to the external capacitor, said system being **characterized in that** said reference voltage is arranged to be sufficiently low for the current supplied by the photovoltaic cell at said reference voltage to be close or substantially equal to the short-circuit current of said photovoltaic cell.

5. System according to claim 4, **characterized in that** any two successive values within said plurality of resistance values define a respective current range for the current able to be supplied by the photovoltaic cell at the reference voltage, each of the current ranges thus defining a range of values for the luminous intensity able to be received or captured by the photovoltaic cell; and **in that** said measuring device is arranged to determine which value range corresponds to the luminous intensity actually received or captured by the photovoltaic cell.

6. Method for measuring the luminous intensity received by a photovoltaic cell (4) whose output is electrically connected to an electrical energy storage unit (6) via a DC-DC converter (8) and to an external capacitor (C1) arranged in parallel to said DC-DC converter, said measuring method being implemented by means of a device (2) for measuring said luminous intensity, whose input terminal (10A) is connected to an output terminal of the photovoltaic cell in parallel to the DC-DC converter and to the external capacitor; said measuring method including the following steps:
A) Connecting a variable resistor (14) between said input terminal of the measuring device and an earth terminal, said variable resistor being arranged to take various values within a plurality of determined resistance values and being programmed by a control unit of the measuring device, and selecting an initial resistance value.
B) Discharging or charging the external capacitor if the voltage at the external capacitor terminals is higher than a reference voltage, respectively lower than said reference voltage, until the voltage at the terminals of external capacitor is substantially equal to the reference voltage.
C) Determining whether said input terminal voltage increases or decreases between a first instant, when said voltage is substantially equal to the reference voltage following step B), and a second subsequent instant given said the control unit.
D) Repeating steps B) and C), either decreasing the value of the variable resistor if the result from step C) in a preceding iteration indicates an increase in said voltage at the input terminal and if the value of the variable resistor in the preceding iteration did not correspond to the minimum value of said plurality of resistance values, or increasing the value of the variable resistor if the result from step C) in a preceding iteration indicates a decrease in voltage at the input terminal and if the value of the variable resistor in the preceding iteration did not correspond to the maximum value of the plurality of resistance values, and performing step D) until the determination, within said plurality of resistance values, of a successive first resistance value and second resistance value at which said output voltage change detector respectively detects a decrease in voltage and an increase in voltage at said input terminal, or, if appropriate, until it is determined that the current supplied by said photovoltaic cell to said output terminal is either lower than the reference voltage divided by the maximum value of said plurality of resistance values, or higher than the reference voltage divided by the minimum value of said plurality of resistance values.

7. Measuring method according to claim 6, **characterized in that** said reference voltage is arranged to be sufficiently low for the current supplied by the photovoltaic cell at said reference voltage to be close or substantially equal to the short-circuit current of said photovoltaic cell.

8. Measuring method according to claim 6 or 7, **characterized in that** a dichotomy algorithm is implemented to select said initial resistance value and during successive selections of resistance values in said step D).

9. Measuring method according to any of claims 6 to 8, **characterized in that** any two successive values within said plurality of resistance values define a respective current range for the current supplied by the photovoltaic cell at said reference voltage, each of the current ranges thus defining a range of values for the luminous intensity able to be received or captured by said photovoltaic cell; and **in that** the measuring method determines the value range corresponding to the luminous intensity actually received or captured by the photovoltaic cell.

10. Measuring method according to any of claims 6 to 9, **characterized in that** the method includes the following subsequent additional phases:
E) Selecting said successive first resistance value or said second resistance value of the variable resistor determined in step D) and leaving the variable resistor connected to said input terminal of the measuring device.
F) After a certain time interval, allowing the system to return to steady state, measuring the voltage (V_{OUT}) at said input terminal by means of an analogue-digital converter and thereby accurately determining the value of the current (I_{OUT}) supplied by said photovoltaic cell.
G) Determining the value of the luminous intensity captured by the photovoltaic cell using the linear characteristic of luminous intensity as a function the short-circuit current for said photovoltaic cell.
